# EUROPÄISCHE PATENTSCHRIFT

(11) **EP 3 399 284 B1**
(45) Veröffentlichungstag und Bekanntmachung des Hinweises auf die Patenterteilung: **10.07.2019**
(21) Anmeldenummer: 17169204.9
(22) Anmeldetag: 03.05.2017
(51) Int. Cl.: G01D 11/24

(54) **SENSOREINHEIT ZUR POSITIONSMESSUNG**
SENSOR UNIT FOR POSITION MEASUREMENT
CAPTEUR DE MESURE DE POSITION

(43) Veröffentlichungstag der Anmeldung: 07.11.2018
(73) Patentinhaber: Dr. Johannes Heidenhain GmbH, 83301 Traunreut (DE)
(72) Erfinder: RISSING, Lutz, 80337 München (DE); STERKEL, Martin, 83209 Prien am Chiemsee (DE)

(56) Entgegenhaltungen:
- EP-A2- 2 063 231
- EP-A2- 2 096 418
- WO-A2-2011/076181
- DE-A1-102013 206 689
- DE-A1-102015 210 099
- US-A1- 2009 243 060

## Beschreibung

Die Erfindung betrifft eine Sensoreinheit zur Positionsmessung beispielsweise für eine Winkel- beziehungsweise Längenmesseinrichtung gemäß dem Anspruch 1.

### GEBIET DER TECHNIK

Winkelmesseinrichtungen werden beispielsweise als Drehgeber zur Bestimmung der Winkellage zweier relativ zueinander drehbarer Maschinenteile verwendet. Darüber hinaus sind Längenmesseinrichtungen bekannt, bei denen eine lineare Verschiebung zweier relativ zueinander verschiebbarer Maschinenteile gemessen wird. Winkelmesseinrichtungen wie auch Längenmesseinrichtungen weisen üblicherweise Sensoreinheiten auf, die relativ zu den Sensoreinheiten bewegbare Bauteile, etwa Winkelskalierungen oder Längenskalierungen beziehungsweise Maßstäbe abtasten und positionsabhängige Signale erzeugen.

Bei optischen Messeinrichtungen sind häufig Lichtquellen und Fotodetektoren auf einer Leiterplatte einer optischen Sensoreinheit montiert. Mit einem Luftspalt von der Leiterplatte gegenüber liegend befindet sich eine optische Skalierung. Nach bekannten Prinzipien können dann von der Position abhängige Signale erzeugt werden.

Häufig werden derartige Messeinrichtungen beziehungsweise Messgeräte für elektrische Antriebe, zur Bestimmung der Relativbewegung bzw. der Relativlage von entsprechenden Maschinenteilen, eingesetzt. In diesem Fall werden die erzeugten Positionswerte einer Folgeelektronik zur Ansteuerung der Antriebe über eine entsprechende Schnittstellenanordnung zugeführt.

### STAND DER TECHNIK

In der DE 198 43 155 A1 wird eine Verschiebungsmesseinrichtung beschrieben, bei welcher die betreffende Sensoreinheit einen IC-Chip aufweist, der auf einem Glassubstrat in einem Harzformblock montiert ist. In der DE 10 2013 206 689 A1 wird eine Sensoreinheit zur Positionsmessung offenbart, wobei die Sensoreinheit ein elektronisches Bauelement aufweist, welches von einem Deckel aus Metall abgedeckt ist.

### ZUSAMMENFASSUNG DER ERFINDUNG

Der Erfindung liegt die Aufgabe zugrunde eine Sensoreinheit zu schaffen, der ein gegenüber äußeren Einflüssen robustes Betriebsverhalten ermöglicht und vergleichsweise wirtschaftlich herstellbar ist.

Diese Aufgabe wird erfindungsgemäß durch die Merkmale des Anspruches 1 gelöst.

Die Sensoreinheit ist zur Positionsmessung eines relativ zur Sensoreinheit bewegbaren Bauteils geeignet, wobei die Sensoreinheit einen Metallkörper umfasst, der zumindest eine erste Ausnehmung aufweist. In der ersten Ausnehmung ist zumindest ein elektronisches Bauelement so angeordnet, dass ein Spalt zwischen dem elektronischen Bauelement und dem Metallkörper vorliegt, wobei der Spalt mit einer elektrisch isolierenden Vergussmasse ausgefüllt ist. Auf dem elektronischen Bauelement und auf der Vergussmasse ist eine elektrisch isolierende erste Schicht aufgebracht. Das elektronische Bauelement ist mit einer Leiterbahn elektrisch kontaktiert, wobei die Leiterbahn in einem ersten Abschnitt durch die erste Schicht hindurch geführt ist und in einem zweiten Abschnitt auf der ersten Schicht verläuft. Insbesondere ist das elektronische Bauelement mit dem ersten Abschnitt der Leiterbahn unmittelbar elektrisch kontaktiert.

Insbesondere ist der Spalt S so ausgestaltet, dass dieser um das elektronische Bauelement herum umlaufend ist, so dass also das elektronische Bauelement in der Ausnehmung umlaufend von der Vergussmasse umgeben ist. Insbesondere besteht kein unmittelbarer Kontakt zwischen dem elektronischen Bauelement und dem Metallkörper. Als Materialen für die Vergussmasse kommen beispielsweise Polymer-Materialien, etwa Epoxid-Harz, aber auch anorganische Kleber in Betracht. Die Vergussmasse kann beispielsweise in einer Vergussanlage eingebracht werden. Ebenso kann die Vergussmasse mit einem Spritzgussverfahren in einer Spritzgussmaschine in den Spalt eingebracht werden.

Die Leiterbahn verläuft im zweiten Abschnitt zumindest teilweise auf der von der Oberfläche des Metallkörpers abgewandten Fläche der ersten Schicht. Die aufmetallisierte Leiterbahn ragt seitlich über den Rand des elektronischen Bauelements hinaus.

Die elektrische Anbindung des elektronischen Bauelements erfolgt also hier ohne die Verwendung von Drähten oder dergleichen. Insbesondere kann auf ein Wire-Bonding beziehungsweise auf ein Drahtbonden verzichtet werden.

In weiterer Ausgestaltung der Erfindung ist die elektrisch isolierende erste Schicht zumindest teilweise auch auf dem Metallkörper aufgebracht und der zweite Abschnitt der Leiterbahn verläuft parallel zu einer ersten Oberfläche des Metallkörpers.

Das elektronische Bauelement kann als aktives Bauelement, beispielsweise als IC-Chip oder als passives Bauelement, beispielsweise als ein Widerstand ausgestaltet sein.

Mit Vorteil umfasst das elektronische Bauelement zumindest einen optischen Sensor.

Vorteilhafterweise umfasst das elektronische Bauelement zumindest eine Lichtquelle. Insbesondere kann das elektronische Bauelement als ein IC-Chip ausgestaltet sein, der unter anderem den zumindest einen optischen Sensor und die Lichtquelle aufweist. Alternativ können die Lichtquelle auf einem ersten elektronischen Bauelement und der optische Sensor auf einem zweiten elektronischen Bauelement angeordnet sein. Bei dieser Bauweise befinden sich das erste und das zweite elektronische Bauelement in ein und derselben Ausnehmung, insbesondere in der genannten ersten Ausnehmung des Metallkörpers.

Alternativ kann das elektronische Bauelement zumindest einen magnetischen Sensor umfassen, insbesondere einen magnetoresistiven Sensor oder einen Hall-Sensor. Gemäß einer weiteren alternativen Ausgestaltung der Erfindung kann das elektronische Bauelement induktive oder kapazitive Sensoren umfassen.

Mit Vorteil weist der Metallkörper eine erste Oberfläche auf, wobei das elektronische Bauelement bündig mit der ersten Oberfläche in der Ausnehmung angeordnet ist. Demgemäß ist das elektronische Bauelement auf gleicher Höhe mit der ersten Oberfläche abschließend angeordnet. Insbesondere liegen die erste Oberfläche und eine Außenfläche des Bauelements in ein und derselben geometrischen Ebene.

Weiterhin kann der zumindest eine optische Sensor bündig mit der ersten Oberfläche angeordnet sein, sofern das elektronische Bauelement zumindest einen optischen Sensor umfasst. Bei einer Ausgestaltung des elektronischen Bauelements mit mehreren optischen Sensoren können auch mehrere Sensoren bündig mit der ersten Oberfläche angeordnet sein.

In weiterer Ausgestaltung der Erfindung umfasst die Sensoreinheit ein Kabel mit einem Schirm, der elektrisch leitend mit dem Metallkörper verbunden ist.

Mit Vorteil weist der Metallkörper eine Dicke von mehr als 0,5 mm, insbesondere eine Dicke von mehr als 1,0 mm, insbesondere eine Dicke von mehr als 1,5 mm auf. Insbesondere weist der Metallkörper weiterhin Befestigungsmittel zur mechanischen Befestigung der Sensoreinheit an einem Maschinenteil auf. Gemäß einer weiteren Ausgestaltung ist das Befestigungsmittel als eine Bohrung durch den Metallkörper beziehungsweise als eine Gewindebohrung ausgestaltet. Insbesondere kann der Metallkörper also nicht nur das elektronische Bauelement aufnehmen, sondern gleichzeitig auch eine Flanschfunktion erfüllen. Weiterhin kann der Metallkörper so ausgestaltet sein, dass dieser eine Kontur aufweist, die mechanisch bearbeitet ist und die als Referenz beziehungsweise Anschlag zum passgenauen Anbau an ein Maschinenteil verwendbar ist.

Der Metallkörper weist eine erste Oberfläche und eine zweite Oberfläche auf, wobei die zweite Oberfläche der ersten Oberfläche gegenüber liegend angeordnet ist, wobei die Sensoreinheit zumindest ein elektronisches Bauteil aufweisen kann, das so angeordnet ist, dass dieses über die zweite Oberfläche hinaus ragt, also nicht bündig zur zweiten Oberfläche angeordnet ist. Weiterhin kann alternativ oder ergänzend die Sensoreinheit zumindest einen Kabelanschluss aufweisen, der so angeordnet ist, dass dieser über die zweite Oberfläche axial hinaus ragt.

In vorteilhafter Weise ist der Metallkörper einstückig ausgestaltet.

Mit Vorteil weist der Metallkörper eine zweite Ausnehmung auf, in der eine Leiterplatte angeordnet ist, die eine erste Fläche und eine der ersten Fläche gegenüber liegende zweite Fläche aufweist. Die Leiterbahn ist dann an der ersten Fläche der Leiterplatte mit der Leiterplatte elektrisch kontaktiert. Außerdem ist ein elektronisches Bauteil auf der zweiten Fläche der Leiterplatte montiert. Die Leiterbahn ist mit Hilfe einer Durchkontaktierung mit dem Bauteil elektrisch verbunden. Insbesondere kann die erste Fläche der Leiterplatte parallel, mit Vorteil bündig, zur ersten Oberfläche des Metallkörpers angeordnet sein. Alternativ oder ergänzend kann die zweite Fläche der Leiterplatte parallel zur zweiten Oberfläche des Metallkörpers angeordnet sein.

Gemäß einem weiteren Aspekt umfasst die Erfindung eine Positionsmesseinrichtung mit einer Sensoreinheit und ein relativ zur Sensoreinheit bewegbares Bauteil. Dabei umfasst das Bauteil eine Skalierung, die als Winkel- oder Längenskalierung ausgestaltet und zu einer inkrementalen oder absoluten Positionsmessung eingerichtet sein kann. Die Sensoreinheit ist in einer Weise gegenüber liegend zur Skalierung angeordnet, dass sich die Leiterbahn zwischen dem Metallkörper und der Skalierung befindet.

Insbesondere verläuft der zweite Abschnitt der Leiterbahn zwischen dem Metallkörper und der Skalierung. Entsprechend befindet sich die erste Schicht zwischen dem Metallkörper und der Skalierung. Unter dem Begriff Skalierung ist ein Körper zu verstehen, der eine inkrementale oder absolute Teilung aufweist und häufig auch als Maßverkörperung bezeichnet wird.

Mit Vorteil ist die das genannte Bauteil der Positionsmesseinrichtung relativ zur Sensoreinheit drehbar und die Skalierung als eine Winkelskalierung ausgestaltet. Alternativ ist das Bauteil relativ zur Sensoreinheit linear verschiebbar und die Skalierung ist als eine Längenskalierung ausgestaltet.

Vorteilhafte Ausbildungen der Erfindung entnimmt man den abhängigen Ansprüchen.

Weitere Einzelheiten und Vorteile der erfindungsgemäßen Sensoreinheit beziehungsweise Positionsmesseinrichtung ergeben sich aus der nachfolgenden Beschreibung eines Ausführungsbeispiels anhand der beiliegenden Figuren.

### KURZE BESCHREIBUNG DER ZEICHNUNGEN

Es zeigen die
- Figur 1: eine Draufsicht auf eine Metalltafel mit Schnitten nach einem ersten Herstellungsschritt der Sensoreinheit,
- Figur 2: eine Draufsicht auf einen einzelnen Metallkörper nach dem ersten Herstellungsschritt der Sensoreinheit,
- Figur 3a: eine Schnittdarstellung eines Teilbereichs der Sensoreinheit nach dem ersten Herstellungsschritt,
- Figur 3b: eine Schnittdarstellung des Teilbereichs der Sensoreinheit nach einem weiteren Herstellungsschritt,
- Figur 3c: eine Schnittdarstellung des Teilbereichs der Sensoreinheit nach einem Aufbringen von Vergussmasse,
- Figur 3d: eine Schnittdarstellung des Teilbereichs der Sensoreinheit nach einem Aufbringen von einer isolierenden ersten Schicht,
- Figur 3e: eine Schnittdarstellung des Teilbereichs der Sensoreinheit nach Erzeugung von Leiterbahnen,
- Figur 3f: eine Schnittdarstellung des Teilbereichs der Sensoreinheit nach einem Aufbringen von einer zweiten isolierenden Schicht,
- Figur 4: eine Draufsicht auf eine bestückte Sensoreinheit,
- Figur 5: eine Seitenansicht auf eine Positionsmesseinrichtung.

### BESCHREIBUNG DER AUSFÜHRUNGSFORMEN

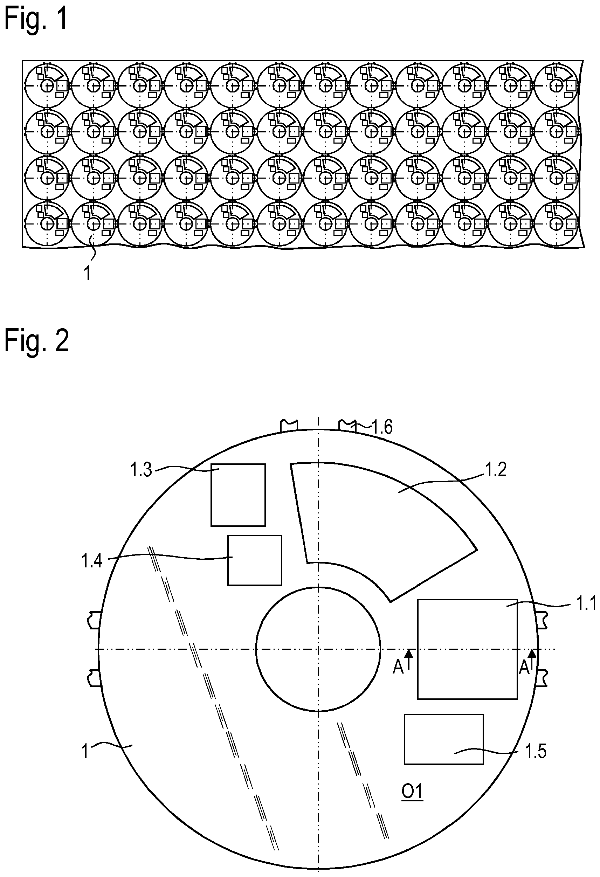

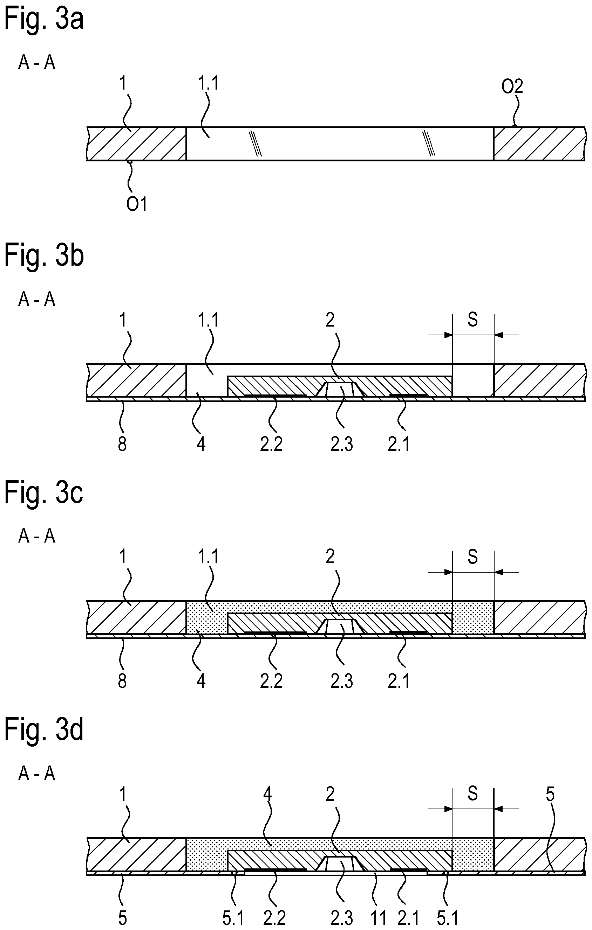

Im Zuge der Herstellung einer Sensoreinheit wird zunächst ein Nutzen beziehungsweise eine Metalltafel bereitgestellt, die im vorgestellten Ausführungsbeispiel eine Stärke beziehungsweise Dicke von 1,0 mm aufweist und aus Aluminium hergestellt ist. In diese Metalltafel werden die in der Figur 1 ersichtlichen Schnittverläufe eingearbeitet, beispielsweise durch einen Laserschneidprozess oder einem Wasserstrahlschneidprozess. Auf diese Weise wird eine Vielzahl von Metallkörpern 1 erzeugt, die eine Gestalt entsprechend der Figur 2 aufweisen. Jeder der Metallkörper 1 weist demnach eine erste Ausnehmung 1.1, eine zweite Ausnehmung 1.2, eine dritte Ausnehmung 1.3, eine vierte Ausnehmung 1.5 und eine fünfte Ausnehmung 1.5 sowie eine zentrale runde Ausnehmung auf. Im Folgenden wird die Erfindung anhand der ersten Ausnehmung 1.1 erläutert, insbesondere mit Hilfe der Schnittdarstellung durch die Linie A - A gemäß den Figuren 3a bis 3f. Die Metallkörper 1 sind in dieser Fertigungsphase nach dem Schneidprozess durch Stege 1.2 miteinander verbunden. Gemäß einem alternativen Herstellungsverfahren können die kreisförmigen Außenkonturen der Metallkörper 1 erst in einem späteren Schritt erzeugt werden.

Auf eine erste Oberfläche O1 der Metalltafel beziehungsweise der Metallkörper 1 wird gemäß der Figur 3b zunächst eine Folie 8 geklebt beziehungsweise auflaminiert. Daraufhin wird in der ersten Ausnehmung 1.1 auf die Folie 8 ein elektronisches Bauelement 2 aufgeklebt, so dass ein Spalt mit der Breite S zwischen dem Rand der ersten Ausnehmung 1.1 und dem Bauelement 2 vorliegt. Im vorgestellten Ausführungsbeispiel ist das Bauelement 2 als IC-Chip ausgestaltet und weist einen ersten optischen Sensor 2.1 (beispielsweise ein erstes Fotodetektorarray) und einen zweiten optischen Sensor 2.2 (beispielsweise ein zweites Fotodetektorarray) auf. Zudem umfasst das Bauelement 2 im vorgestellten Ausführungsbeispiel eine Lichtquelle 2.3, die hier in einer Kavität des Bauelements 2 angeordnet ist. Das Bauelement 2 wird so auf der Folie 8 platziert, dass dieses bündig mit der ersten Oberfläche O1 in der ersten Ausnehmung 1.1 angeordnet ist. Insbesondere sind hier der erste optische Sensor 2.1 und der zweite optische Sensor 2.2 bündig mit der ersten Oberfläche O1 in der ersten Ausnehmung 1.1 angeordnet.

Im nächsten Herstellungsschritt gemäß der Figur 3c wird das Volumen um das Bauelement 2 in der ersten Ausnehmung 1.1 mit einer Vergussmasse 4 ausgefüllt. In diesem Zusammenhang kann beispielsweise ein Dispenser oder eine Vergussanlage beziehungsweise eine Moldingeinrichtung verwendet werden um die Vergussmasse 4 aufzutragen. Im vorgestellten Ausführungsbeispiel kann durch die Fixierung beziehungsweise Klebung des Bauelements 2 in Verbindung mit einem schonenden Vergussverfahren sichergestellt werden, dass keine Verschiebung des Bauelements 2 relativ zum Metallkörper 1 während des Aufbringens der Vergussmasse 4 auftritt, so dass das Bauelements 2 mit seinen optischen Sensoren 2.1, 2.2 und der Lichtquelle 2.3 exakt relativ zum Metallkörper 1 platziert ist.

Nach dem Vergießen und Aushärten der Vergussmasse 4 wird die Folie 8 entfernt.

Darauffolgend wird eine isolierende erste Schicht 5, insbesondere eine Schicht aus Polyimid, auf die erste Oberfläche O1 des Metallkörpers 1 und auf die mit dieser ersten Oberfläche O1 bündig verlaufenden Oberflächen der Vergussmasse 4 und des elektronischen Bauelements 2 aufgetragen beziehungsweise auflaminiert (siehe die Figur 3d). Diese erste Schicht 5 wird unter Verwendung eines fotochemischen Verfahrens so strukturiert, dass Durchgangsöffnungen 5.1 für später herzustellende Leiterbahnen 6 vorliegen. Ebenso wird im vorgestellten Ausführungsbeispiel in der ersten Schicht 5 eine Öffnung 11 erzeugt, durch welche die Lichtquelle 2.3 und die optischen Sensoren 2.1, 2.2 freigelegt werden. Alternativ kann insbesondere bei einer geringen Dicke der ersten Schicht 5 und / oder bei geeigneten optischen Eigenschaften der ersten Schicht 5 auf eine Erzeugung der Öffnung 11 verzichtet werden.

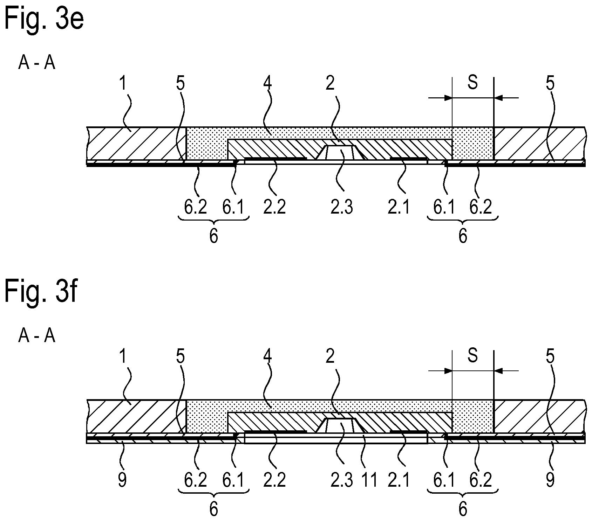

Im Anschluss daran wird gemäß der Figur 3e die auf die erste Schicht 5 eine Metallschicht, die im vorgestellten Ausführungsbeispiel mehrlagig - insbesondere zweilagig - aufgebaut ist, aufgebracht. Diese Metallschicht wird so bearbeitet, dass letztlich die Leiterbahnen 6 gemäß der Figur 3e durch einen selektiven Leiterbahnaufbau erzeugt werden. Im Ergebnis liegen dann Leiterbahnen 6 vor, die jeweils einen ersten Abschnitt 6.1 und einen zweiten Abschnitt 6.2 aufweisen. In ihrem ersten Abschnitt 6.1 sind die Leiterbahnen 6 durch die erste Schicht 5 hindurch geführt, insbesondere durch die Durchgangsöffnungen 5.1. Außerdem wird im ersten Abschnitt ein elektrischer Kontakt zwischen Leiterbahn 6 und elektronischen Bauelement 2 hergestellt. Weiterhin verlaufen die Leiterbahnen 6 im zweiten Abschnitt 6.2 auf der ersten Schicht 5 parallel zur ersten Oberfläche O1 und sind von dieser entsprechend der Dicke der ersten Schicht 5 beabstandet. Auf die Leiterbahnen 6 wird danach eine elektrisch isolierende zweite Schicht 9 beziehungsweise eine Passivierungsschicht aufgebracht.

Optional können auch noch weitere Schichten und weitere Leiterbahnen erzeugt werden. In vorteilhafter Weise ist der gesamte Schichtaufbau auf der ersten Oberfläche O1 des Metallköpers 1, also die Summe der Dicken der Leiterbahnen und der isolierenden Schichten nicht größer als 0,1 mm, insbesondere nicht größer als 0,05 mm.

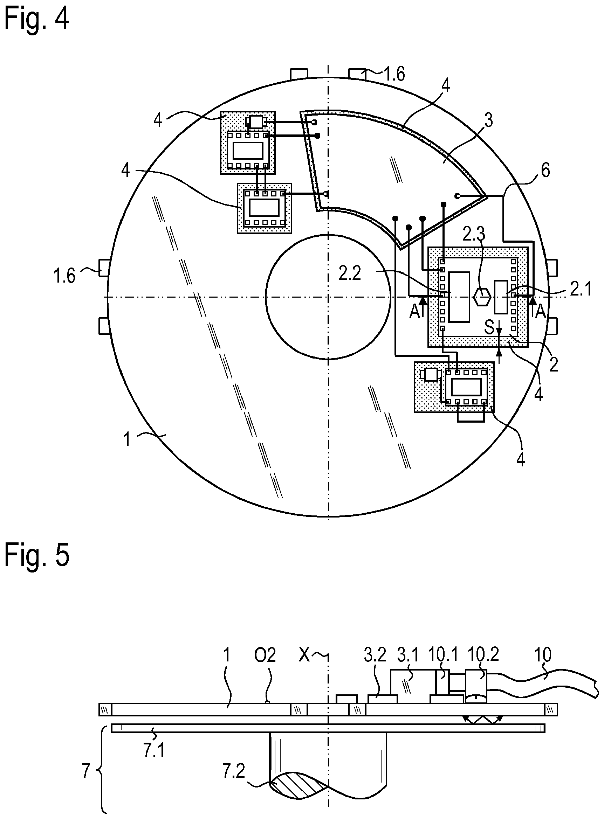

Im Zuge des Herstellungsprozesses werden zugleich die dritte bis fünfte Ausnehmung 1.3 - 1.5 auf die gleiche Weise mit elektronischen Bauelementen bestückt wie die erste Ausnehmung 1.1, entsprechend vergossen und elektrisch kontaktiert. In der zweiten Ausnehmung 1.2 wird eine Leiterplatte 3 platziert und vergossen, die eine erste Fläche und eine der ersten Fläche gegenüber liegende zweite Fläche aufweist. Die Leiterbahnen 6 werden an der ersten Fläche der Leiterplatte 3 mit der Leiterplatte 3 elektrisch kontaktiert, insbesondere mit einer metallisierten Fläche einer Durchkontaktierung. Auf der Leiterplatte 3 werden zudem beispielsweise ein Kabelanschluss 3.1 (hier ein Steckverbinder) und weitere elektronische Bauteile 3.2 rückseitig also auf der zweiten Fläche montiert, wie dies in der Figur 5 ersichtlich ist. Demnach sind die weiteren elektronischen Bauteile 3.2 und der Kabelanschluss 3.1 auf einer zweiten Fläche der Leiterplatte 3 angeordnet, die der ersten Fläche der Leiterplatte 3 gegenüber liegt. Eine elektrische Verbindung der Leiterbahnen 6 mit den elektronischen Bauteilen 3.2 und / oder dem Kabelanschluss 3.1 wird mit Hilfe von Durchkontaktierungen erreicht.

Im vorgestellten Ausführungsbeispiel ragen die elektronischen Bauteile 3.2 und der Kabelanschluss 3.1 über eine zweite Oberfläche O2 des Metallkörpers axial hinaus, wobei die zweite Oberfläche O2 der ersten Oberfläche O1 gegenüber liegend angeordnet ist (Figur 3a, 3f).

In der Figur 4 ist eine Draufsicht auf die so hergestellte Sensoreinheit gezeigt. Im Anschluss an diese Herstellungsschritte können die Metallkörper 1 voneinander getrennt beziehungsweise vereinzelt werden.

Im weiteren Fortgang des Herstellungsprozesses wird ein mehradriges Kabel 10, das einen Schirm (siehe Figur 5) und einen Verbinder 10.2 aufweist, mit dem Kabelanschluss 3.1 der Leiterplatte 3 verbunden. Des Weiteren wird eine Schelle 10.2 um den Schirm gelegt und mit Hilfe der Gewindebohrung im Metallkörper 1 und einer Schraube 2.8 am Metallkörper 1 befestigt. Somit ist nicht nur eine mechanische Verbindung zwischen dem Metallkörper 1 und dem Kabel 10 hergestellt, sondern auch eine elektrische Verbindung zwischen dem Metallkörper 1 und dem Schirm.

Die Sensoreinheit gemäß der Anordnung in Figur 4 kann nun beispielsweise rückseitig mit elektrisch isolierendem Material umspritzt werden, so dass die zweite Fläche der Leiterplatte 3, die elektronischen Bauteile 3.2 sowie der Kabelanschluss 3.1 zum Anschluss des Kabels 10 vor äußeren Einflüssen geschützt sind. Die Umspritzung kann in diesem Fall auch gleichzeitig als Zugentlastung für das Kabel 10 dienen.

In der Figur 5 ist ein Prinzip-Bild eines Messsystems dargestellt, welches die erfindungsgemäße Sensoreinheit und ein relativ dazu bewegbares (hier relativ zum Sensoreinheit drehbares) Bauteil 7 umfasst. Das Bauteil 7 besteht aus einer Welle 7.1 und einer Skalierung 7.1, hier eine Winkelskalierung. Im vorgestellten Ausführungsbeispiel umfasst die Skalierung 7.1 zwei konzentrische Teilungs- oder Codespuren, die mit einem Auflichtverfahren reflektiv abtastbar sind.

Die Sensoreinheit kann nun beispielsweise an einem Maschinenteil, etwa an einem Motorgehäuse, befestigt werden. Zu diesem Zweck kann der Metallkörper 1 abweichend von den Darstellungen in den Figuren Befestigungsmittel etwa in Form von Bohrungen aufweisen. Auf diese Weise ist eine einfache und präzise Montage der Sensoreinheit möglich. Üblicherweise dient das Bauteil 7 beziehungsweise die Winkelskalierung als Rotor und wird an einem um die Drehachse X drehbaren Maschinenteil befestigt. Dagegen bildet dann die Sensoreinheit den Stator der als Winkelmesseinrichtung ausgestalteten Positionsmesseinrichtung, so dass dieser an einem stehenden Maschinenteil fixiert wird. Im zusammengebauten Zustand der Positionsmesseinrichtung stehen sich das Bauteil 7 und die Sensoreinheit mit vergleichsweise geringem Luftspalt einander gegenüber, wobei der Luftspalt kleiner ist als in dem Prinzip-Bild der Figur 5 dargestellt.

Im Betrieb des Messsystems emittiert die Lichtquelle 2.3 Licht, das gemäß dem in der Figur 5 angedeuteten Strahlengang von den Teilungsspuren der Skalierung 7.1 reflektiert wird und auf die optischen Sensoren 2.1, 2.2 fällt, die das einfallende Licht in Fotoströme beziehungsweise elektrische Signale umwandeln. Die Drehachse X verläuft durch das Zentrum des Bauteils 7 beziehungsweise der Skalierung 7.1. Bei einer Relativdrehung zwischen dem Bauteil 7 und der Sensoreinheit ist so in den optischen Sensoren 2.1, 2.2 ein von der jeweiligen Winkelstellung abhängiges Signal erzeugbar.

Durch die oben beschriebene Bauweise der Sensoreinheit kann auf vergleichsweise einfache und kostengünstige Art eine Anordnung geschaffen werden, die eine genaue Einstellung des Spaltes zwischen den optischen Sensoren 2.1, 2.2 und der Skalierung 7.1 beziehungsweise zwischen der Lichtquelle 2.3 und der Skalierung 7.1 erlaubt. Insbesondere ist bauartbedingt sichergestellt, dass die der Skalierung 7.1 zugewandte Oberfläche des elektronischen Bauelements 2 bündig mit der ersten Oberfläche O1 des Metallkörpers angeordnet ist. Durch die exakte Positionierung des elektronischen Bauelements 2 relativ zum Metallkörper 1 kann nach erfolgter Montage beziehungsweise Fixierung des Metallkörpers 1 an einem Maschinenteil gewährleistet werden, dass das elektronische Bauelement 2, insbesondere die optischen Sensoren 2.1, 2.2 und die Lichtquelle 2.3 präzise platziert sind.

Der auf der Leiterplatte 3 montierte Baustein 3.2 arbeitet als Auswerteelement für die Signale. In logischen Schaltungen auf dem Digitalteil des Bausteins 3.2 werden die Positionswerte resultierend aus der Abtastung der einzelnen Teilungsspuren ermittelt, beziehungsweise berechnet. Die Positionswerte können über das Kabel 10 an eine Folgeelektronik, beispielsweise eine Numerische Steuerung einer Maschine, übertragen werden. Eine mit der Sensoreinheit ausgestattete Winkelmesseinrichtung dient demnach zur Erfassung einer Winkelposition zwischen der Sensoreinheit, der an einem Maschinenteil festlegbar ist und dem Bauteil 7 mit der Skalierung 7.1.

Alternativ kann auch der Baustein, der als Auswerteelement für die Signale dient, ohne eine Leiterplatte in einer weiteren Ausnehmung im Metallkörper 1, umgeben von Vergussmasse 4, angeordnet sein.

Durch die vorgestellte Bauweise wird eine Sensoreinheit bereitgestellt, die insbesondere bezüglich Einflüssen von äußeren elektromagnetischen Feldern unempfindlich ist, weil der Metallkörper 1, welcher insbesondere mit dem Schirm des Kabels 10 elektrisch verbunden ist, selbst abschirmend wirkt.

Zudem wird die im Bauelement 2 erzeugte Wärme wirksam über die Vergussmasse 4 auf den Metallkörper 1 abgeleitet beziehungsweise verteilt, so dass eine reduzierte Betriebstemperatur des elektronischen Bauelements 2 erreicht wird, was sich positiv auf die Messgenauigkeit auswirkt.

## Patentansprüche

1. Sensoreinheit zur Positionsmessung eines relativ zur Sensoreinheit bewegbaren Bauteils (7), wobei die Sensoreinheit einen Metallkörper (1) umfasst, der eine erste Ausnehmung (1.1) aufweist, wobei
ein elektronisches Bauelement (2) in der ersten Ausnehmung (1.1) so angeordnet ist, dass ein Spalt (S) zwischen dem elektronischen Bauelement (2) und dem Metallkörper (1) vorliegt, wobei der Spalt (S) mit einer elektrisch isolierenden Vergussmasse (4) ausgefüllt ist, wobei
auf dem elektronischen Bauelement (2) und auf der Vergussmasse (4) eine elektrisch isolierende erste Schicht (5) aufgebracht ist,
das elektronische Bauelement (2) mit einer Leiterbahn (6) elektrisch kontaktiert ist, wobei die Leiterbahn (6) in einem ersten Abschnitt (6.1) durch die erste Schicht (5) hindurch geführt ist und in einem zweiten Abschnitt (6.2) auf der ersten Schicht (5) verläuft, wobei das elektronische Bauelement (2) mit dem ersten Abschnitt (6.1) der Leiterbahn (6) unmittelbar elektrisch kontaktiert ist.

2. Sensoreinheit gemäß dem Anspruch 1, wobei die elektrisch isolierende erste Schicht (5) auch auf dem Metallkörper (1) aufgebracht ist und der zweite Abschnitt (6.2) der Leiterbahn (6) parallel zu einer ersten Oberfläche (O1) des Metallkörpers (1) verläuft.

3. Sensoreinheit gemäß einem der vorhergehenden Ansprüche, wobei das elektronische Bauelement (2) zumindest einen optischen Sensor (2.1, 2.2) umfasst.

4. Sensoreinheit gemäß einem der vorhergehenden Ansprüche, wobei das elektronische Bauelement (2) zumindest eine Lichtquelle (2.3) umfasst.

5. Sensoreinheit gemäß einem der vorhergehenden Ansprüche, wobei das elektronische Bauelement (2) zumindest einen magnetischen Sensor umfasst.

6. Sensoreinheit gemäß einem der vorhergehenden Ansprüche, wobei der Metallkörper (1) eine erste Oberfläche (O1) aufweist und das elektronische Bauelement (2) bündig mit der ersten Oberfläche (O1) in der ersten Ausnehmung (1.1) angeordnet ist.

7. Sensoreinheit gemäß einem der vorhergehenden Ansprüche, wobei das elektronische Bauelement (2) zumindest einen optischen Sensor (2.1, 2.2) umfasst und der Metallkörper (1) eine erste Oberfläche (O1) aufweist, wobei der zumindest eine optische Sensor (2.1, 2.2) bündig mit der ersten Oberfläche (O1) angeordnet ist.

8. Sensoreinheit gemäß einem der vorhergehenden Ansprüche, wobei der Metallkörper (1) eine erste Oberfläche (O1) und eine der ersten Oberfläche (O1) gegenüber liegende zweite Oberfläche (O2) aufweist, wobei die Sensoreinheit zumindest ein elektronisches Bauteil (3.2) aufweist, das so angeordnet ist, dass dieses über die zweite Oberfläche (O2) hinaus ragt.

9. Sensoreinheit gemäß einem der vorhergehenden Ansprüche, wobei der Metallkörper (1) eine zweite Ausnehmung (1.2) aufweist, in der eine Leiterplatte (3) angeordnet ist, die eine erste Fläche und eine der ersten Fläche gegenüber liegende zweite Fläche aufweist, wobei die Leiterbahn (6) an der ersten Fläche der Leiterplatte (3) mit der Leiterplatte (3) elektrisch kontaktiert ist und ein elektronisches Bauteil (3.2) auf der zweiten Fläche der Leiterplatte (3) montiert ist, wobei die Leiterbahn (6) mit Hilfe einer Durchkontaktierung mit dem Bauteil (3.2) elektrisch verbunden ist.

10. Sensoreinheit gemäß einem der vorhergehenden Ansprüche, wobei die Sensoreinheit ein Kabel (10) mit einem Schirm umfasst und der Schirm elektrisch leitend mit dem Metallkörper (1) verbunden ist.

11. Sensoreinheit gemäß einem der vorhergehenden Ansprüche, wobei der Metallkörper (1) eine erste Oberfläche (O1) und eine der ersten Oberfläche (O1) gegenüber liegende zweite Oberfläche (O2) aufweist, wobei die Sensoreinheit zumindest einen Kabelanschluss (3.1) aufweist, der so angeordnet ist, dass dieser über die zweite Oberfläche (O2) hinaus ragt.

12. Sensoreinheit gemäß einem der vorhergehenden Ansprüche, wobei der Metallkörper (1) eine Dicke von mehr als 0,5 mm aufweist.

13. Positionsmesseinrichtung, die eine Sensoreinheit gemäß einem der vorhergehenden Ansprüche und ein relativ zur Sensoreinheit bewegbares Bauteil (7) umfasst, wobei das Bauteil (7) eine Skalierung (7.1) umfasst und die Sensoreinheit in einer Weise gegenüber liegend zur Skalierung (7.1) angeordnet ist, dass sich die Leiterbahn (6) zwischen dem Metallkörper (1) und der Skalierung (7.1) befindet.

14. Positionsmesseinrichtung gemäß dem Anspruch 13, wobei das Bauteil (7) relativ zur Sensoreinheit drehbar ist und die Skalierung (7.1) als eine Winkelskalierung ausgestaltet ist.

15. Positionsmesseinrichtung gemäß dem Anspruch 13, wobei das Bauteil (7) relativ zur Sensoreinheit linear verschiebbar ist und die Skalierung (7.1) als eine Längenskalierung ausgestaltet ist.

## Claims

1. Sensor unit for measuring the position of a component (7) that can be moved relative to the sensor unit, wherein the sensor unit comprises a metal body (1) which has a first opening (1.1), wherein
an electronic component (2) is arranged in the first opening (1.1) such that there is a gap (5) between the electronic component (2) and the metal body (1), wherein the gap (S) is filled with an electrically insulating potting compound (4), wherein
an electrically insulating first layer (5) is applied to the electronic component (2) and to the potting compound (4),
a conductor track (6) makes electrical contact with the electronic component (2), wherein the conductor track (6) is led through the first layer (5) in a first section (6.1) and extends on the first layer (5) in a second section (6.2), wherein electric contact with the electronic component (2) is made directly by the first section (6.1) of the conductor track (6) .

2. Sensor unit according to Claim 1, wherein the electrically insulating first layer (5) is also applied to the metal body (1), and the second section (6.2) of the conductor track (6) extends parallel to a first surface (01) of the metal body (1) .

3. Sensor unit according to one of the preceding claims, wherein the electronic component (2) comprises at least one optical sensor (2.1, 2.2).

4. Sensor unit according to one of the preceding claims, wherein the electronic component (2) comprises at least one light source (2.3).

5. Sensor unit according to one of the preceding claims, wherein the electronic component (2) comprises at least one magnetic sensor.

6. Sensor unit according to one of the preceding claims, wherein the metal body (1) has a first surface (01) and the electronic component (2) is arranged flush with the first surface (O1) in the first opening (1.1).

7. Sensor unit according to one of the preceding claims, wherein the electronic component (2) comprises at least one optical sensor (2.1, 2.2), and the metal body (1) has a first surface (O1), wherein the at least one optical sensor (2.1, 2.2) is arranged flush with the first surface (01).

8. Sensor unit according to one of the preceding claims, wherein the metal body (1) has a first surface (01) and a second surface (O2) located opposite the first surface (01), wherein the sensor unit has at least one electronic component (3.2), which is arranged such that the latter projects beyond the second surface (O2).

9. Sensor unit according to one of the preceding claims, wherein the metal body (1) has a second opening (1.2), in which there is arranged a printed circuit board (3), which has a first surface and a second surface located opposite the first surface, wherein the conductor track (6) makes electric contact with the printed circuit board (3) on the first surface thereof, and an electronic component (3.2) is mounted on the second surface of the printed circuit board (3), wherein the conductor track (6) is connected electrically to the component (3.2) with the aid of a via.

10. Sensor unit according to one of the preceding claims, wherein the sensor unit comprises a cable (10) with a screen, and the screen is electrically conductively connected to the metal body (1).

11. Sensor unit according to one of the preceding claims, wherein the metal body (1) has a first surface (01) and a second surface (O2) located opposite the first surface (O1), wherein the sensor unit has at least one cable connection (3.1) which is arranged such that the latter projects beyond the second surface (O2).

12. Sensor unit according to one of the preceding claims, wherein the metal body (1) has a thickness of more than 0.5 mm.

13. Position measuring device which comprises a sensor unit according to one of the preceding claims and a component (7) that can be moved relative to the sensor unit, wherein the component (7) comprises a scale (7.1) and the sensor unit is arranged opposite the scale (7.1) in such a way that the conductor track (6) is located between the metal body (1) and the scale (7.1).

14. Position measuring device according to Claim 13, wherein the component (7) can be rotated relative to the sensor unit and the scale (7.1) is equipped as an angle scale.

15. Position measuring device according to Claim 13, wherein the component (7) can be displaced in a linear manner relative to the sensor unit and the scale (7.1) is equipped as a length scale.

## Revendications

1. Unité de détection destinée à la mesure de position d'un élément structural (7) mobile par rapport à l'unité de détection, l'unité de détection comportant un corps métallique (1) qui possède une première cavité (1.1),
un composant électronique (2) étant disposé dans la première cavité (1.1) de telle sorte qu'il existe un interstice (S) entre le composant électronique (2) et le corps métallique (1), l'interstice (S) étant rempli avec une masse de scellement (4) électriquement isolante,
une première couche (5) électriquement isolante étant appliquée sur le composant électronique (2) et sur la masse de scellement (4),
le composant électronique (2) étant mis en contact électrique avec une piste conductrice (6), la piste conductrice (6) étant introduite à travers la première couche (5) dans une première portion (6.1) et s'étendant sur la première couche (5) dans une deuxième portion (6.2), le composant électronique (2) étant mis en contact électrique directement avec la première portion (6.1) de la piste conductrice (6).

2. Unité de détection selon la revendication 1, la première couche (5) électriquement isolante étant également appliquée sur le corps métallique (1) et la deuxième portion (6.2) de la piste conductrice (6) s'étendant parallèlement à une première surface (01) du corps métallique (1).

3. Unité de détection selon l'une des revendications précédentes, le composant électronique (2) comportant au moins un capteur optique (2.1, 2.2).

4. Unité de détection selon l'une des revendications précédentes, le composant électronique (2) comportant au moins une source de lumière (2.3).

5. Unité de détection selon l'une des revendications précédentes, le composant électronique (2) comportant au moins un capteur magnétique.

6. Unité de détection selon l'une des revendications précédentes, le corps métallique (1) possédant une première surface (O1) et le composant électronique (2) étant disposé dans la première cavité (1.1) à fleur de la première surface (01).

7. Unité de détection selon l'une des revendications précédentes, le composant électronique (2) comportant au moins un capteur optique (2.1, 2.2) et le corps métallique (1) possédant une première surface (O1), l'au moins un capteur optique (2.1, 2.2) étant disposé à fleur de la première surface (O1).

8. Unité de détection selon l'une des revendications précédentes, le corps métallique (1) possédant une première surface (O1) et une deuxième surface (O2) à l'opposé de la première surface (O1), l'unité de détection possédant au moins un composant électronique (3.2) qui est disposé de telle sorte que celui-ci fait saillie au-dessus de la deuxième surface (O2).

9. Unité de détection selon l'une des revendications précédentes, le corps métallique (1) possédant une deuxième cavité (1.2) dans laquelle est disposé un circuit imprimé (3), lequel possède une première surface et une deuxième surface à l'opposé de la première surface, la piste conductrice (6) étant mise en contact électrique avec le circuit imprimé (3) au niveau de la première surface du circuit imprimé (3) et un composant électronique (3.2) étant monté sur la deuxième surface du circuit imprimé (3), la piste conductrice (6) étant reliée électriquement à l'épaisseur supérieure à 0,5 mm (3.2) à l'aide d'un contact traversant.

10. Unité de détection selon l'une des revendications précédentes, l'unité de détection comportant un câble (10) muni d'un blindage et le blindage étant relié électriquement de manière conductrice au corps métallique (1).

11. Unité de détection selon l'une des revendications précédentes, le corps métallique (1) possédant une première surface (O1) et une deuxième surface (O2) à l'opposé de la première surface (O1), l'unité de détection possédant au moins un raccord pour câble (3.1) qui est disposé de telle sorte que celui-ci fait saillie au-dessus de la deuxième surface (O2).

12. Unité de détection selon l'une des revendications précédentes, le corps métallique (1) ayant une épaisseur supérieure à 0,5 mm.

13. Dispositif de mesure de position, qui comprend une unité de détection selon l'une des revendications précédentes et un élément structural (7) mobile par rapport à l'unité de détection, l'élément structural (7) comportant une graduation (7.1) et l'unité de détection étant disposée à l'opposé de la graduation (7.1) de telle sorte que la piste conductrice (6) se trouve entre le corps métallique (1) et la graduation (7.1).

14. Dispositif de mesure de position selon la revendication 13, l'élément structural (7) étant rotatif par rapport à l'unité de détection et la graduation (7.1) étant réalisée sous la forme d'une graduation angulaire.

15. Dispositif de mesure de position selon la revendication 13, l'élément structural (7) pouvant coulisser linéairement par rapport à l'unité de détection et la graduation (7.1) étant réalisée sous la forme d'une graduation longitudinale.
